# EUROPEAN PATENT APPLICATION

(11) **EP 4 593 266 A1**
(43) Date of publication of application: **30.07.2025**
(21) Application number: 25153552.2
(22) Date of filing: 23.01.2025
(51) Int. Cl.: H02K 11/33

(54) **DRIVE MODULE FOR ELECTRIC MOTOR**

(30) Priority: 29.01.2024 CN 202410126988
(71) Applicant: ZF Friedrichshafen AG, 88046 Friedrichshafen (DE)
(72) Inventor: Xu, Qing, Shanghai 201615 (CN); Yuan, Shaozhi, Shanghai 201615 (CN)
(74) Representative: ZF Friedrichshafen AG

(57) **Abstract**

The present application provides a drive module for an electric motor, the drive module comprising: a power board, which is in the shape of a ring or a partial ring and comprises a first insulating layer, an intermediate layer, and a second insulating layer, the intermediate layer having a receiving portion for receiving a plurality of power chips, the first insulating layer covering the receiving portion, and a source and a drain of each of the power chips leading out of the first insulating layer; a heat sink disposed at a back surface of the power board, the heat sink being in the shape of a ring or a partial ring; a control board connected to the power board, the control board being in the shape of a ring or a partial ring; an alternating current connector connected to the power board; and a housing having a cavity for receiving the power board, the heat sink and the control board, the housing and the cavity being both in the shape of a ring. In the present application, the power chips are distributed over a plurality of copper substrates, so that the power chips can be arranged on the power board in the shape of a ring while enabling the size of the drive module to be reduced. In addition, the drive module of the present application can be shaped to match the shape of the electric motor.

## Description

### Technical Field

The present application relates mainly to the field of electric motors, and in particular to a drive module for an electric motor.

### Background Art

A power unit is an important component in an electric vehicle. The power unit comprises an electric motor and a drive module. The electric motor is used to power an electric vehicle, and the drive module is used to convert direct current output from a battery into alternating current and to deliver the alternating current to the electric motor. Improving the shape matching between the drive module and the electric motor, and reducing the size of the drive module help to reduce the space occupied by the power unit.

### Summary of the Invention

The technical problem to be solved by the present application is to provide a drive module for an electric motor, which drive module can arrange power chips on a power board in the shape of a ring while enabling the size of the drive module to be reduced. In addition, the drive module of the present application can match the shape of the electric motor.

In order to solve the technical problem mentioned above, the present application provides a drive module for an electric motor, the drive module comprising: a power board, which is in the shape of a ring or a partial ring and comprises a first insulating layer, an intermediate layer, and a second insulating layer, the intermediate layer being located between the first insulating layer and the second insulating layer and having a receiving portion within which a plurality of power chips are disposed, the first insulating layer covering the receiving portion, and a source and a drain of each of the power chips leading out of the first insulating layer; a heat sink disposed at a back surface of the power board, the heat sink being in the shape of a ring or a partial ring; a control board connected to the power board via a first connection member, a second connection member and a third connection member, the control board being in the shape of a ring or a partial ring; an alternating current connector connected to the power board, the alternating current connector having an alternating current output port configured to be connected to the electric motor; and a housing having a cavity for receiving the power board, the heat sink and the control board, the housing and the cavity being both in the shape of a ring.

In an embodiment of the present application, the first insulating layer has a plurality of through holes, and the drain and the source lead out to a top surface of the first insulating layer through corresponding through holes.

In an embodiment of the present application, the first connection member, the second connection member, and the third connection member each have one end connected to a DC or AC pad on the power board, and the other end connected to the control board.

In an embodiment of the present application, the drive module further comprises a connection piece disposed between the power board and the heat sink, wherein the connection piece is in the shape of a ring or a partial ring.

In an embodiment of the present application, the connection piece is made of a resin.

In an embodiment of the present application, the drive module further comprises a capacitor connected to the power board, wherein the capacitor is in the shape of a ring or a partial ring.

In an embodiment of the present application, the drive module further comprises a bracket connected to the alternating current connector to secure the alternating current connector.

In an embodiment of the present application, a plurality of heat dissipation columns are provided on a surface of the heat sink away from the power board, projections of the plurality of heat dissipation columns in an axial direction of the heat sink overlapping with the plurality of power chips.

In an embodiment of the present application, the housing further has an axially penetrating through hole, wherein the through hole is configured to be sleeved on a power output shaft of the electric motor.

In an embodiment of the present application, the housing is in the shape of a circular ring, which has an outer diameter of 200 mm to 300 mm.

In an embodiment of the present application, the plurality of power chips are divided into three groups, the three groups of power chips being arranged at equal angular intervals on the power board.

In an embodiment of the present application, the ring is a circular ring, and the partial ring is a part of a circular ring.

In the prior art, the size of a circuit where the power chips are located is relatively large, which results in the power chips being unable to be disposed on a ring-shaped power board and also results in the size of the drive module being relatively large. In the present application, the power chips are distributed over a plurality of copper substrates, so that the power chips can be arranged on the power board in the shape of a ring while enabling the size of the drive module to be reduced. Furthermore, the housing of the present application is in the shape of a ring, which can match the shape of the electric motor, whereas the housing in the prior art is square, which cannot match the shape of the electric motor.

### Brief Description of the Drawings

The accompanying drawings are included to provide a further understanding of the present application and are incorporated into and constitute a part of the present application, show embodiments of the present application, and serve to, together with the description, explain the principles of the present application. In the accompanying drawings:
FIGS. 1 and 2 are schematic perspective views of a drive module for an electric motor according to an embodiment of the present application;
FIG. 3 is an exploded view of the drive module for an electric motor of FIG. 1;
FIG. 4 is a schematic perspective view of a power board according to an embodiment of the present application;
FIG. 5A is a schematic front view of the power board of FIG. 4;
FIG. 5B is a schematic cross-sectional view of the power board of FIG. 5A taken along a dashed line A-A;
FIG. 6 is a schematic perspective view of a heat sink according to an embodiment of the present application;
FIG. 7 is a schematic perspective view of a power board connected to a heat sink according to an embodiment of the present application;
FIG. 8 is a schematic perspective view of a capacitor according to an embodiment of the present application;
FIG. 9 is a schematic perspective view of a power board, a capacitor, a filter, and an alternating current connector assembled according to an embodiment of the present application;
FIG. 10 is a schematic front view of a housing according to an embodiment of the present application; and
FIGS. 11 to 13 are schematic perspective views of the connection between a power board and a control board.

### List of reference signs:

| | | | | | |
|---|---|---|---|---|---|
| Drive module for electric motor | 100 | Body | 121 | Bracket | 190 |
| Power board | 110 | Front surface | 121a | Coolant pipeline | 210 |
| Front surface | 111 | Heat dissipation column | 122 | Signal port | 220 |
| Back surface | 112 | Control board | 130 | Battery connection port | 230 |
| Power chip | 113 | Alternating current connector | 140 | Welding layer | 240 |
| Recess | 114 | Housing | 150 | Copper pillar | 250, 260 |
| Copper substrate | 115 | Cavity | 151 | First connection member | 271 |
| First insulating layer | 116 | Through hole | 152 | Second connection member | 271 |
| Intermediate layer | 117 | Filter | 160 | Third connection member | 273 |
| Second insulating layer | 118 | Connection piece | 170 | | |
| Heat sink | 120 | Capacitor | 180 | | |

### Detailed Description of Embodiments

To describe technical solutions of embodiments of the present application more clearly, the accompanying drawings required for describing the embodiments will be briefly described below. Obviously, the accompanying drawings described below show merely some of the examples or embodiments of the present application, and those of ordinary skill in the art would also have applied the present application to other similar scenarios according to these accompanying drawings without involving any creative effort. Unless obvious from the language context or otherwise illustrated, the same reference numerals in the drawings represent the same structure or operation.

As shown in the present application and the claims, unless the context expressly indicates otherwise, the words "a", "an", "said", and/or "the" do not specifically refer to the singular, but may also include the plural. Generally, the terms "include" and "comprise" only suggest that the expressly identified steps and elements are included, but these steps and elements do not constitute an exclusive list, and the method or device may further include other steps or elements.

Unless otherwise indicated specifically, the relative arrangement, numerical expressions and values of the components and steps set forth in these embodiments do not limit the scope of the present application. In addition, it should be understood that, for ease of description, the dimensions of the various parts shown in the accompanying drawings are not drawn according to the actual proportional relationship. Techniques, methods and devices known to those of ordinary skill in the relevant field may not be discussed in detail, but where appropriate, the techniques, methods and devices should be considered as part of the authorized description. In all of the examples shown and discussed here, any specific value should be construed as merely exemplary but not limiting. Therefore, other examples of exemplary embodiments may have different values. It should be noted that similar reference signs and letters refer to similar items in the following drawings. Therefore, once an item is defined in one of the drawings, it is not necessary to further discuss the item in subsequent drawings.

In the description of the present application, it should be understood that orientations or position relationships indicated by orientation terms such as "front, rear, up, down, left, and right", "transverse, vertical, perpendicular, and horizontal", and "top and bottom" are generally based on orientations or position relationships shown in the drawings and are merely for ease of description of the present application and simplification of the description, rather than indicating and implying that the apparatuses or elements referred to must have a specific orientation or be constructed and operated in a specific orientation if there is no explanation to the contrary, and therefore cannot be construed as limiting the scope of protection of the present application. The orientation terms "interior and exterior" refer to inside and outside relative to a contour of each component itself.

For ease of description, spatial relative terms such as "over ...", "above ...", "on an upper surface of ...", and "on ..." may be used here to describe a spatial position relationship between one device or feature and another device or feature as shown in the figures. It should be understood that the spatial relative terms are intended to encompass different orientations of the device in use or operation, in addition to the orientation of the device described in the figure. For example, if devices in the figure are inverted, the device described as "above" or "over" another device or structure will later be positioned as "below" or "under" another device or structure. Therefore, the exemplary term "above ..." may include both "above ..." and "below ..." orientations. The device may also be positioned in other different ways (rotated by 90 degrees or in other orientations), and the spatial relative descriptions used here are interpreted accordingly.

Furthermore, it should be noted that, the use of terms such as "first" and "second" to define parts is merely for ease of facilitating differentiation of the corresponding parts. If not otherwise stated, the above terms have no special meanings and thus cannot be construed as limiting the scope of protection of the present application. Furthermore, although the terms used in the present application are selected from well-known common terms, some of the terms mentioned in the description of the present application may have been selected by the applicant according to his or her determination, and the detailed meaning thereof is described in the relevant section described herein. Furthermore, the present application must be understood, not simply by the actual terms used but also by the meanings encompassed by each term.

A drive module for an electric motor of the present application will be described below with reference to embodiments.

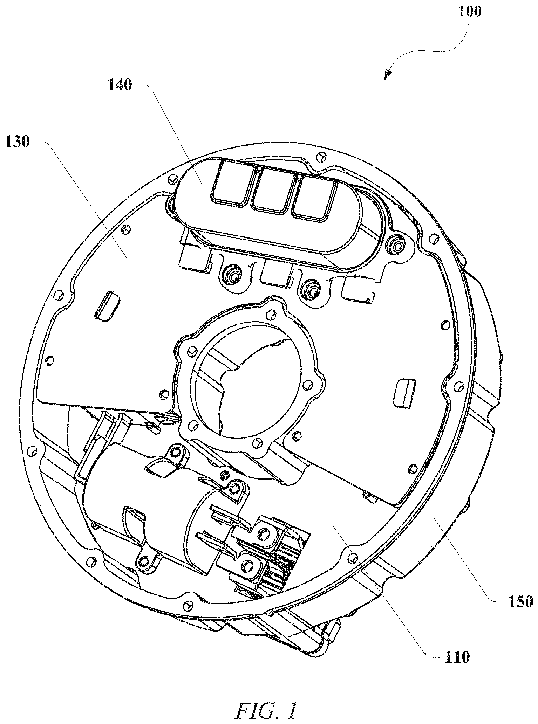

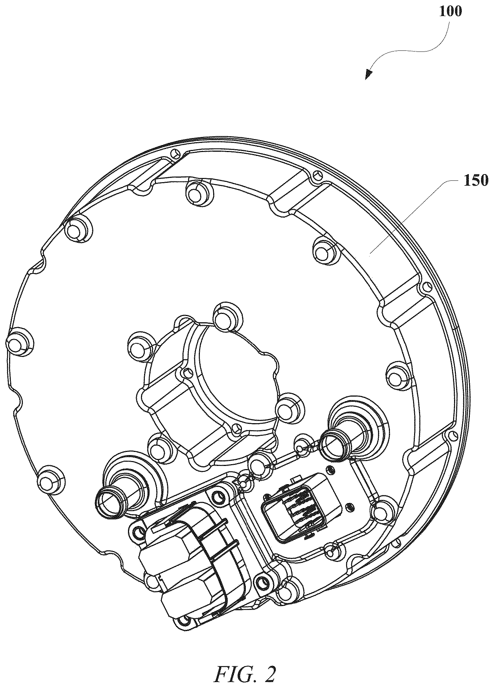

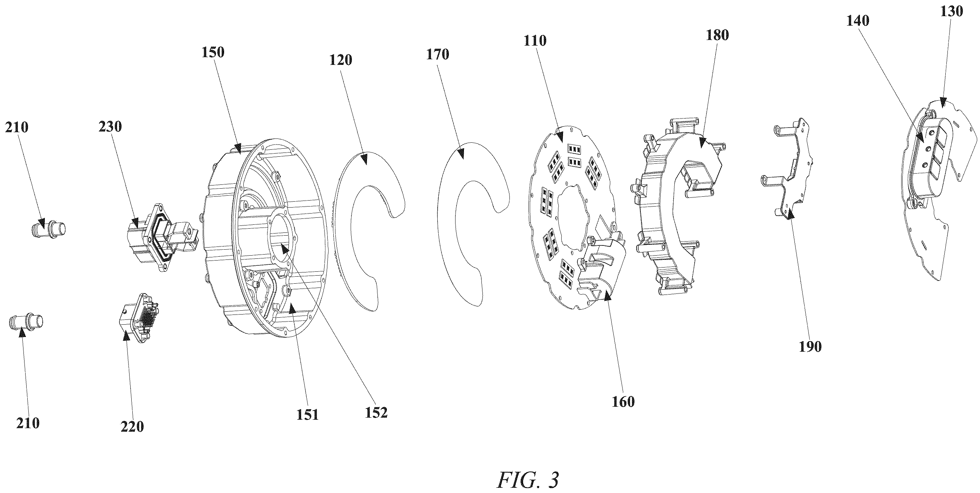

FIGS. 1 and 2 are schematic perspective views of a drive module 100 for an electric motor according to an embodiment, and FIG. 3 is an exploded view of the drive module 100 for an electric motor in FIG. 1. In the embodiment of FIGS. 1-3, the drive module 100 for an electric motor comprises a power board 110, a heat sink 120, a control board 130, an alternating current connector 140 and a housing 150.

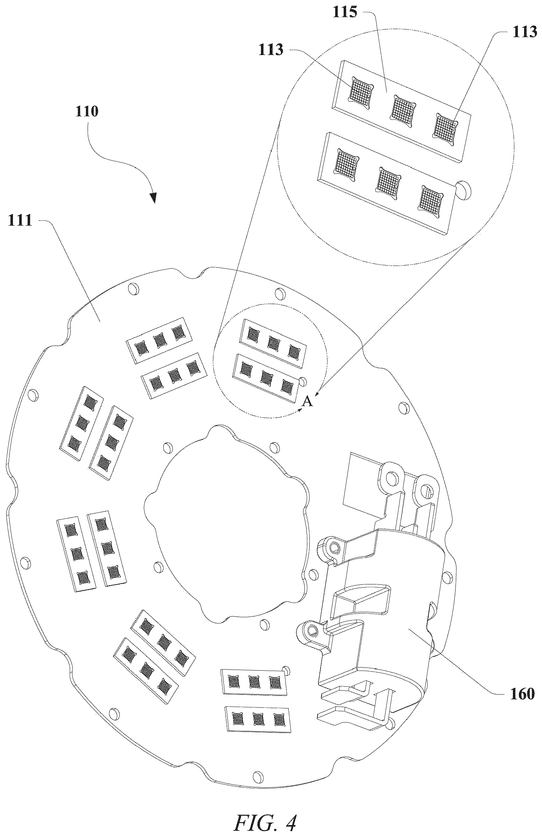

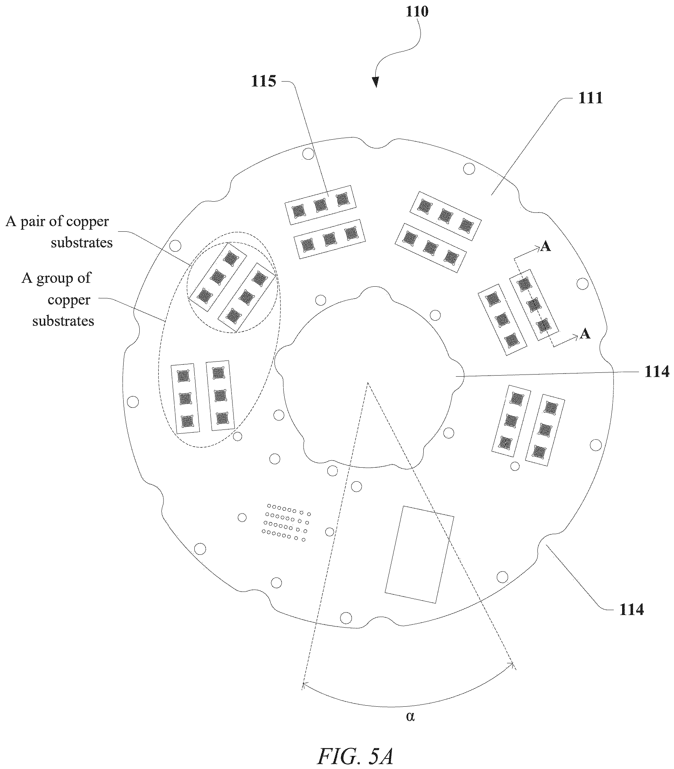

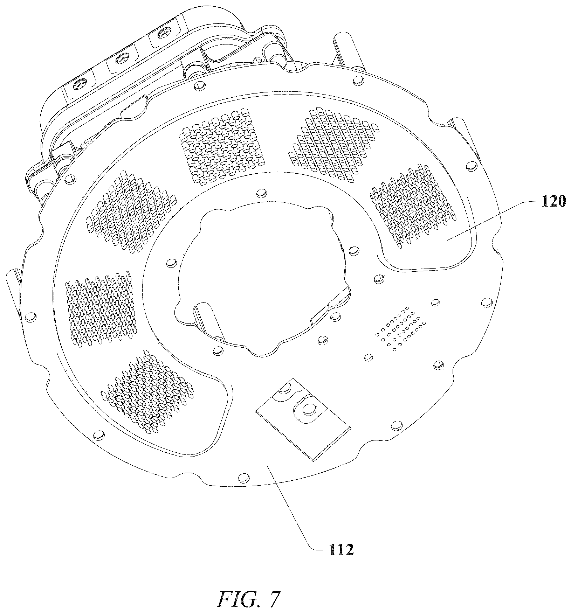

Specifically, reference is made to a schematic perspective view of the power board 110 in an embodiment shown in FIG. 4, and to a schematic front view of the power board 110 of FIG. 4 shown in FIG. 5A. A schematic enlarged view of circle A is shown at the upper right corner of FIG. 4. The power board 110 is in the shape of a ring with a front surface 111 and a back surface 112 (as shown in FIG. 7) opposite to each other, and the power board 110 has a plurality of power chips 113. The power chips 113 may be silicon carbide substrate power chips, silicon substrate power chips, or silicon carbide-silicon hybrid substrate power chips.

In FIGS. 4 and 5A, an outer periphery and an inner periphery of the power board 110 are not strictly circular because there are a plurality of recesses 114 distributed on both the outer periphery and the inner periphery. In other embodiments, the power board 110 may have no recesses 114, in which case the outer periphery and the inner periphery of the power board 110 are strictly circular. The power board 110 may not be in the shape of a circular ring, for example, it may be in the shape of an elliptical ring. In some embodiments, the power board 110 may be in the shape of a partial ring. Specifically, the power board 110 in FIG. 5A is in the shape of a circular ring, and the "partial ring" refers to a portion having a central angle α. The value of the central angle α may be set according to requirements. It should be understood that when the power board 110 is in the shape of a non-circular ring, for example, an elliptical ring, the "partial ring" refers to a portion of the ring that is located between two lines which intersect the centre of the ellipse. The above description also applies to the following text.

Referring to FIGS. 4 and 5A, three power chips 113 are sequentially arranged on a copper substrate 115, and two copper substrates 115 are arranged adjacent to each other in a radial direction of the power board 110. For convenience of description, the two copper substrates 115 arranged adjacent to each other in the radial direction are referred to as a pair of copper substrates. A group of copper substrates comprises two pairs of copper substrates arranged adjacent to each other in a circumferential direction of the power board 110, and the power board 110 is provided with three groups of copper substrates. The three groups of copper substrates are arranged at equal angular intervals, and each group of copper substrates corresponds to one phase of three-phase alternating current. In other words, the 36 power chips 113 are divided into three groups, each corresponding to one phase of the three-phase alternating current. In some other embodiments, four copper substrates 115 in each group may be arranged adjacent to one another in the radial direction of the power board 110, or four copper substrates 115 in each group may be arranged adjacent to one another in the circumferential direction of the power board 110. In short, the specific arrangement of the 12 copper substrates 115 can be flexibly arranged according to the size and shape of the power board 110. In addition, the number of power chips 113 on each group of copper substrates is not limited to 12, and the number of power chips can be adjusted according to requirements.

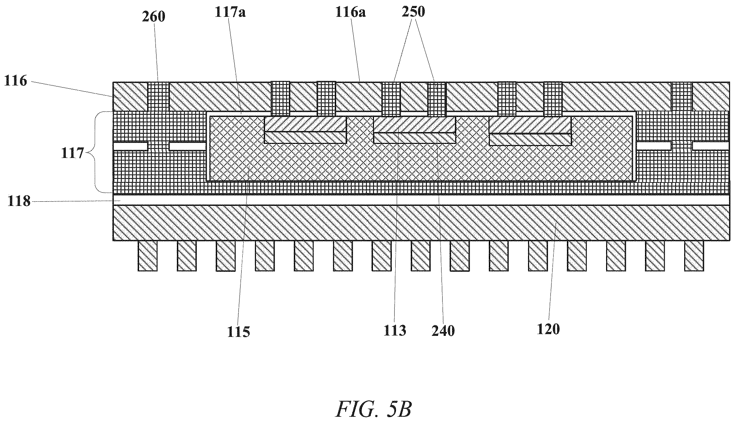

A main body of the power board 110 is a printed circuit board (PCB), and the copper substrates 115 are connected to the printed circuit board by chip on board (COB) packaging technology. Specifically, referring to a schematic cross-sectional view of the power board of FIG. 5A shown in FIG. 5B along the dotted line A-A, the power board 110 comprises a first insulating layer 116, an intermediate layer 117, and a second insulating layer 118. The intermediate layer 117 is located between the first insulating layer 116 and the second insulating layer 118. The intermediate layer 117 has a receiving portion 117a. In order to make the overall structure of the drive module compact, the copper substrates 115 and the power chips 113 are both embedded in the power board, that is, placed in the receiving portion 117a, and the first insulating layer 116 covers the receiving portion 117a. The first insulating layer 116 may be a part of a printed circuit board (e.g., an insulating part of a top surface of the printed circuit board that is used to implement electrical isolation between lead-out portions of a source, a drain and a gate of the power chip 113). The second insulating layer 118 may be used to insulate the power board 110 from the heat sink 120.

The power chip 113 may be connected to the copper substrate 115 via a welding layer 240. The first insulating layer 116 has a plurality of through holes, and the drain and the source of the power chip 113 lead out to the top surface 116a of the first insulating layer 116 through corresponding through holes. Specifically, the source of the power chip 113 leads out to the top surface 116a through a copper pillar 250 located in the through hole, and the drain leads out to the top surface 116a through a copper pillar 260 located in the through hole.

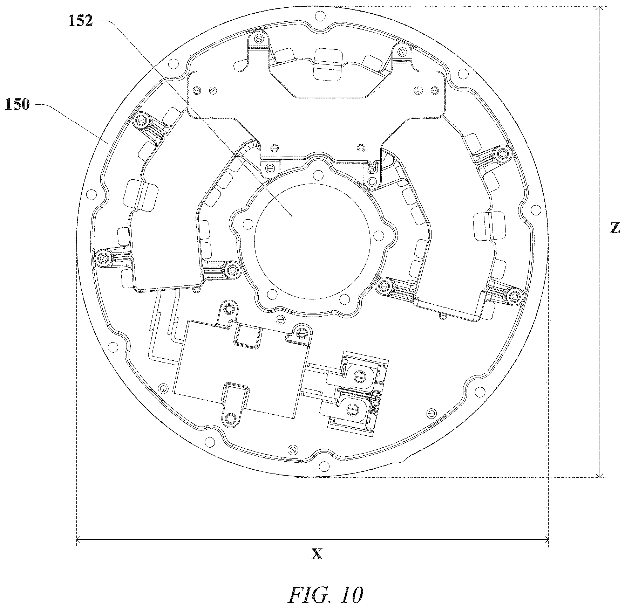

It should be noted that in FIGS. 4, 5A and 13, for ease of description, the copper substrates 115 and the power chips 113 are shown. When the copper substrates 115 are connected to the printed circuit board by the chip on board packaging technology, the copper substrates 115 and the power chips 113 cannot be observed in the actual case in FIGS. 4, 5A and 13, but only the copper pillars can be observed. The copper pillars also act as DC and AC pads. In the prior art, the size of a circuit where the power chips are located is relatively large, which results in the power chips being unable to be disposed on a ring-shaped power board and also results in the size of the drive module being relatively large. In the present application, the power chips are distributed over a plurality of copper substrates, so that the power chips can be arranged on the power board in the shape of a ring while enabling the size of the drive module to be reduced. For example, referring to a schematic front view of the housing 150 shown in FIG. 10, the arrangement of the power chips 113 in FIG. 4 is used, and the housing 150 has a dimension X of 300 mm and a dimension Z of 300 mm. However, the housing in the prior art has a dimension of 400 mm corresponding to the dimension X, and a dimension of 300 mm corresponding to the dimension Z. Furthermore, the housing 150 of the present application is in the shape of a ring, which can match the shape of the electric motor, whereas the housing in the prior art is square, which cannot match the shape of the electric motor.

Referring to FIG. 4, in an embodiment, the drive module further comprises a filter 160. The filter 160 is disposed on the front surface 111. FIG. 4 schematically illustrates the filter 160 for ease of description, but the filter 160 is not part of the power board 110.

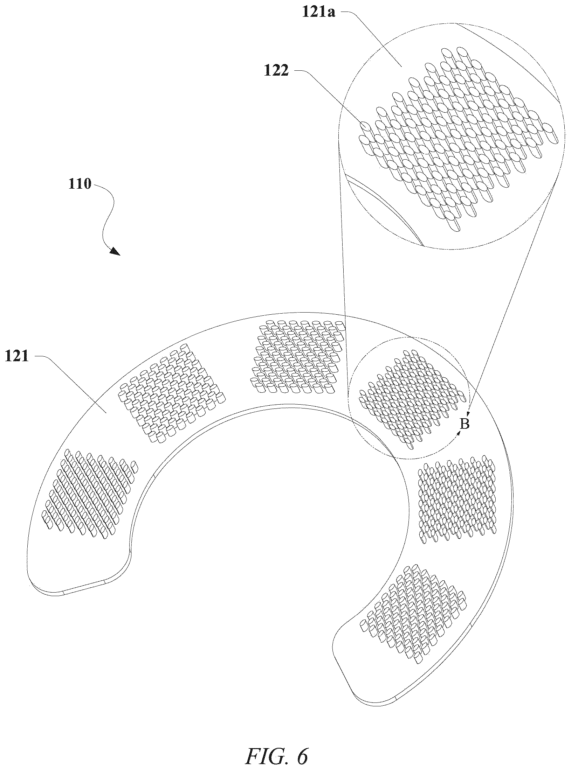

FIG. 6 is a schematic perspective view of the heat sink 120 in an embodiment, and a schematic enlarged view of circle B is shown at the upper right corner of FIG. 6. In the embodiment of FIG. 6, the heat sink 120 is in the shape of a partial ring. In other embodiments, the heat sink 120 may be in the shape of a ring. A main body portion 121 of the heat sink 120 has a front surface 121a and a back surface opposite to each other, and a plurality of heat dissipation columns 122 are provided on the front surface 121a. FIG. 7 is a schematic perspective view of a power board 110 connected to a heat sink 120 according to an embodiment. Referring to FIGS. 4, 6 and 7, the heat dissipation columns 122 on the front surface 121a may be divided into six sections, with the heat dissipation columns in each section corresponding to a pair of copper substrates 115. The back surface of the heat sink 120 is connected to the back surface 112 of the power board 110, and projections of the heat dissipation columns in each section in an axial direction of the heat sink 120 overlap with a corresponding pair of copper substrates 115, so that heat dissipated by each pair of copper substrates 115 can be transferred quickly to the heat dissipation columns in the corresponding section. The heat dissipation column 122 may be made of metallic copper or metallic aluminium, and the material of the main body portion 121 may be the same as or different from the material of the heat dissipation column 122.

Referring to FIG. 3, in an embodiment, the drive module further comprises a connection piece 170. With reference to FIG. 7, the connection piece 170 is disposed between the back surface 112 of the power board 110 and the heat sink 120 to connect the power board 110 to the heat sink 120. The connection piece 170 is in the shape of a ring or a partial ring. Preferably, the connection piece 170 is of the same shape and size as the heat sink 120, so that the cost of the connection piece 170 can be reduced while ensuring that the connection effect of the connection piece 170 meets the requirements. In an embodiment, the connection piece 170 is made of a resin. The resin has good shear resistance, so that the reliability of the connection between the heat sink 120 and the power board 110 can be improved, while the resin can also function to insulate heat sink 120 from the power board 110. In addition, the resin has a high thermal conductivity and can quickly transfer heat from the power board 110 to the heat sink 120.

Referring to FIGS. 1 and 3, the control board 130 is in the shape of a partial ring, and in other embodiments may be in the shape of a ring. The control board 130 is connected to the power board 110, between which electrical energy and/or signals can be transmitted through the above connection.

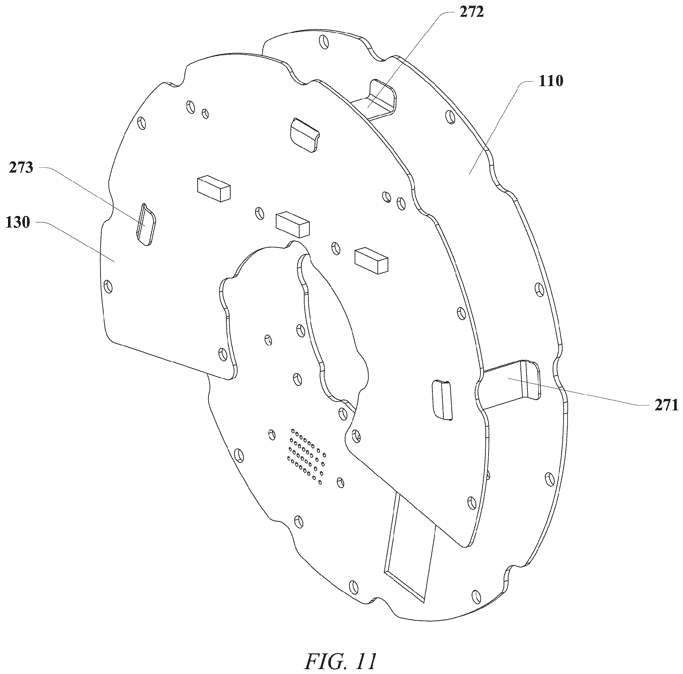

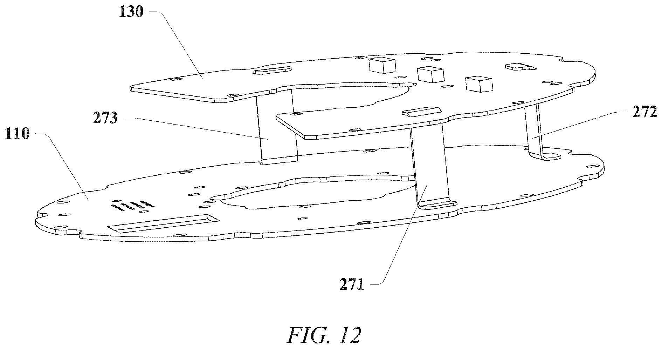

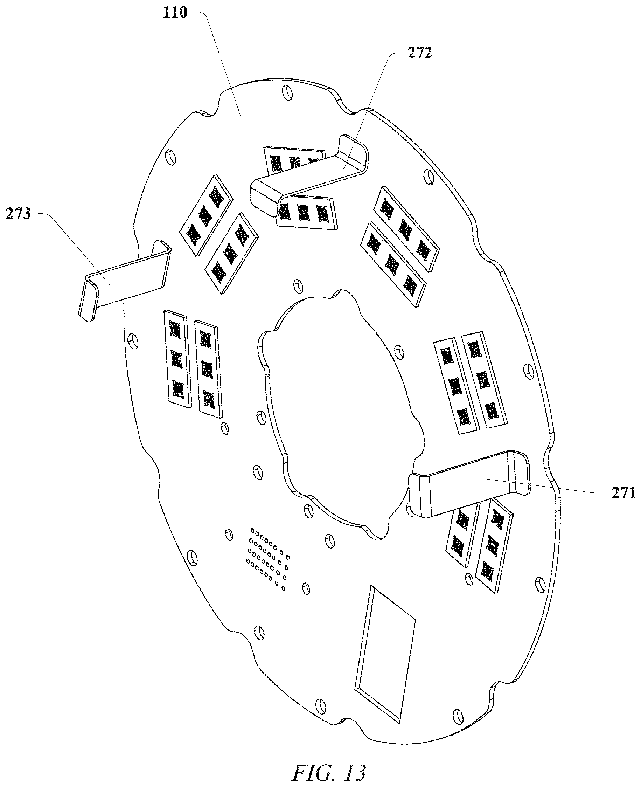

FIGS. 11 to 13 are schematic perspective views of the connection between the power board 110 and the control board 130. Referring to FIGS. 11 to 13, a first connection member 271, a second connection member 272 and a third connection member 273 are provided between the control board 130 and the power board 110. The first connection member 271, the second connection member 272 and the third connection member 273 each have one end disposed between two corresponding pairs of copper substrates (as shown in FIG. 13) and connected to the power board 110, for example, to a DC pad or an AC pad on the power board 110, and the other end connected to the control board 130. With the above connection, the power board 110 can transmit the direct current converted from the alternating current to the control board 130. The connection between the first connection member 271, the second connection member 272 and the third connection member 273, on one hand, and the power board 110 and the control board 130, on the other hand, may be laser welding, selective soldering, etc. The first connection member 271, the second connection member 272 and the third connection member 273 may be copper foils.

The alternating current connector 140 is connected to the power board 110. The alternating current connector 140 has an alternating current output port configured to be connected to the electric motor. The drive module may deliver the alternating current to the electric motor through the alternating current output port. In an embodiment, the alternating current connector 140 is integrated with an EMC (electromagnetic compatibility) magnetic ring, thereby improving the interference resistance of the alternating current connector 140.

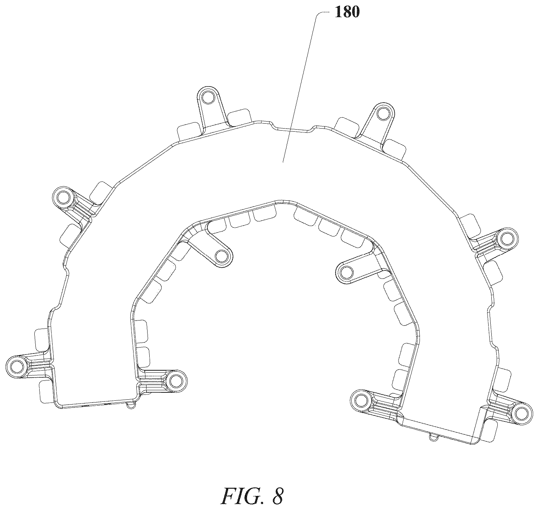

Referring to the schematic perspective views of the capacitor 180 shown in FIGS. 3 and 8, in an embodiment, the drive module further comprises a capacitor 180. The capacitor 180 is in the shape of a partial ring. In other embodiments, the capacitor 180 may be in the shape of a ring. The capacitor 180 is connected to the power board 110. For example, the capacitor 180 may be connected to the power board 110 by welding.

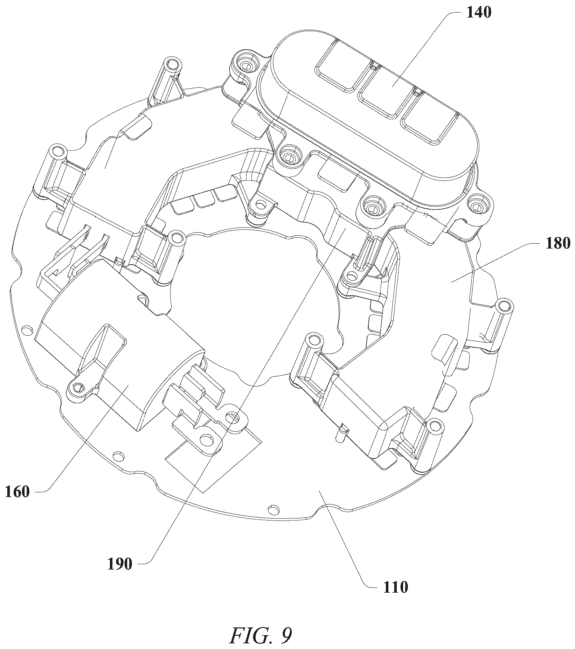

FIG. 9 is a schematic perspective view of a power board 110, a capacitor 180, a filter 160, and an alternating current connector 140 assembled according to an embodiment. Referring to FIG. 9, the filter 160 and the capacitor 180 are disposed on the front surface of the power board 110, and the connection between the filter 160 and the power board 110, and the connection between the capacitor 180 and the power board 110 may be implemented in a bolted manner. The alternating current connector 140 is disposed on a surface of the capacitor 180 away from the power board 110, and may be connected to the alternating current connector 140 and the capacitor 180 via a bracket 190. The filter 160 may filter the direct current from a battery and then delivers the processed direct current to the capacitor 180, the capacitor 180 may then deliver the direct current to the power board 110, and the power board 110 may convert the direct current to alternating current, and deliver the alternating current to the control board 130.

Referring to FIGS. 3 and 10, the housing 150 in the shape of a ring has a cavity 151 in the shape of a ring, and a through hole 152 penetrating in an axial direction thereof. The cavity 151 may be used to receive the power board 110, the connection piece 170, the heat sink 120 and the control board 130. In some embodiments, the housing 150 is in the shape of a circular ring, which has an outer diameter of 200 mm to 300 mm, such as 210 mm, 230 mm, 250 mm, 270 mm, or 290 mm. The outer diameter of the housing 150 may be set according to the size of the shape profile of an electrode that matches the housing. The through hole 152 is configured to be sleeved on a power output shaft of the electric motor. The housing 150 may be connected to the electric motor via a flange. The housing 150 of the present application is in the shape of a ring and can match the shape of the electric motor, so that the space occupied by the drive module can be reduced. In some embodiments, a single-housing solution may be employed to seal the entire inverter with a housing of the electric motor.

In an embodiment, the housing 150 is made of metallic aluminium and may be formed by a die casting process.

Referring to FIG. 3, a coolant may be supplied to the drive module through a coolant pipeline 210. The drive module may further comprise a signal port 220 and a battery connection port 230. The drive module may communicate with the outside via the signal port 220, and may be connected to the battery via the battery connection port 230.

The basic concepts have been described above. Obviously, for those skilled in the art, the above disclosure of the present application is merely used as an example and does not constitute a limitation on the present application. Although not explicitly stated herein, various modifications, improvements and amendments may be made to the present application by those skilled in the art. Such modifications, improvements and amendments are suggested in the present application, and therefore, such modifications, improvements and amendments still fall within the spirit and scope of the exemplary embodiments of the present application.

Meanwhile, the present application uses specific terms to describe the embodiments of the present application. For example, "one embodiment", "an embodiment", and/or "some embodiments" mean a feature, structure, or characteristic associated with at least one embodiment of the present application. Therefore, it should be emphasized and noted that "an embodiment" or "one embodiment" or "an alternative embodiment" mentioned twice or more in different positions in the description does not necessarily refer to the same embodiment. Furthermore, some features, structures, or characteristics of the one or more embodiments of the present application may be combined appropriately.

Similarly, it should be noted that to simplify the expressions in the disclosure of the present application to assist in the understanding of one or more embodiments of the present application, a plurality of features may sometimes be incorporated into an embodiment and accompanying drawing, or a description thereof in the foregoing description of the embodiments of the present application. However, such a method of disclosure does not mean that the subject of the present application requires more features than those mentioned in the claims. In fact, the features of the embodiments are less than all the features of a single embodiment disclosed above.

Figures for describing the quantity of components and attributes are used in some embodiments. It should be understood that such figures for use in the description of the embodiments are modified with modifiers "about," "approximately," or "substantially" in some examples. Unless otherwise stated, "about", "approximately", or "substantially" indicates that the stated number allows for a variation of ± 20%. Accordingly, in some embodiments, numerical parameters used in the description and the claims are all approximations, which can change depending on desired characteristics of individual embodiments. In some embodiments, for the numerical parameters, a specified number of valid digits should be considered, and a general bit retention method is used. Although numerical fields and parameters used to confirm the breadth of their ranges in some embodiments of the present application are approximations, such values are set to the extent practicable as precisely as possible in specific embodiments.

While the present application has been described with reference to the specific embodiments at hand, those of ordinary skill in the art would realize that the above embodiments are merely used to illustrate the present application, and various equivalent changes or substitutions can also be made without departing from the spirit of the present application. Therefore, any change and variation made to the above embodiments within the substantial spirit and scope of the present application shall fall within the scope of the claims of present application.

## Claims

1. A drive module for an electric motor, **characterized by** comprising:
a power board, which is in the shape of a ring or a partial ring and comprises a first insulating layer, an intermediate layer, and a second insulating layer, the intermediate layer being located between the first insulating layer and the second insulating layer and having a receiving portion within which a plurality of power chips are disposed, the first insulating layer covering the receiving portion, and a source and a drain of each of the power chips leading out of the first insulating layer;
a heat sink disposed at a back surface of the power board, the heat sink being in the shape of a ring or a partial ring;
a control board connected to the power board via a first connection member, a second connection member and a third connection member, the control board being in the shape of a ring or a partial ring;
an alternating current connector connected to the power board, the alternating current connector having an alternating current output port configured to be connected to the electric motor; and
a housing having a cavity for receiving the power board, the heat sink and the control board, the housing and the cavity being both in the shape of a ring.

2. The drive module of claim 1, **characterized in that** the first insulating layer has a plurality of through holes, and the drain and the source lead out to a top surface of the first insulating layer through corresponding through holes.

3. The drive module of claim 1, **characterized in that** the first connection member, the second connection member, and the third connection member each have one end connected to a DC pad or an AC pad on the power board, and the other end connected to the control board.

4. The drive module of claim 1, **characterized by** further comprising a connection piece disposed between the power board and the heat sink, wherein the connection piece is in the shape of a ring or a partial ring.

5. The drive module of claim 4, **characterized in that** the connection piece is made of a resin.

6. The drive module of claim 1, **characterized by** further comprising a capacitor connected to the power board, wherein the capacitor is in the shape of a ring or a partial ring.

7. The drive module of claim 1, **characterized by** further comprising a bracket connected to the alternating current connector to secure the alternating current connector.

8. The drive module of claim 1, **characterized in that** a plurality of heat dissipation columns are provided on a surface of the heat sink away from the power board, projections of the plurality of heat dissipation columns in an axial direction of the heat sink overlapping with the plurality of power chips.

9. The drive module of claim 1, **characterized in that** the housing further has an axially penetrating through hole, wherein the through hole is configured to be sleeved on a power output shaft of the electric motor.

10. The drive module of claim 1, **characterized in that** the housing is in the shape of a circular ring, which has an outer diameter of 200 mm to 300 mm.

11. The drive module of claim 1, **characterized in that** the plurality of power chips are divided into three groups, the three groups of power chips being arranged at equal angular intervals on the power board.

12. The drive module of any one of claims 1 to 11, **characterized in that** the ring is a circular ring, and the partial ring is a part of a circular ring.
